# EUROPÄISCHE PATENTSCHRIFT

(11) **EP 2 939 861 B1**
(45) Veröffentlichungstag und Bekanntmachung des Hinweises auf die Patenterteilung: **14.07.2021**
(21) Anmeldenummer: 15000118.8
(22) Anmeldetag: 17.01.2015
(51) Int. Cl.: B60K 37/06, G06F 3/0482, H03K 17/98

(54) **Bediensystem für ein Fahrzeug, insbesondere für ein Nutzfahrzeug**
Operating system for a vehicle, in particular a commercial vehicle
Système de commande pour un véhicule, notamment pour un véhicule utilitaire

(30) Priorität: 31.03.2014 DE 102014004538
(43) Veröffentlichungstag der Anmeldung: 04.11.2015
(73) Patentinhaber: MAN Truck & Bus SE, 80995 München (DE)
(72) Erfinder: Schopka, Martin, 80809 München (DE); Arnold, Claus, 93161 Sinzing (DE); Güllich, Johannes, 80335 München (DE); Mohra, Holger, 80805 München (DE); Kupitza, Rudolf, 82275 Emmering (DE); Zimmermann, Andreas, 80995 München (DE)
(74) Vertreter: Liebl, Thomas

(56) Entgegenhaltungen:
- WO-A1-2008/129974
- DE-A1- 10 056 307
- DE-A1-102009 058 592
- DE-A1-102011 110 863
- JP-A- 2008 059 796

## Beschreibung

Die Erfindung betrifft ein Bediensystem für ein Fahrzeug, insbesondere für ein Nutzfahrzeug, nach dem Oberbegriff des Patentanspruches 1, ein Verfahren zur Bedienung eines Bedienmenüs eines Fahrzeugs, insbesondere eines Nutzfahrzeugs, nach dem Oberbegriff des Patentanspruches 13 und ein Fahrzeug mit dem Bediensystem nach Patentanspruch 14.

Moderne Fahrzeuge weisen regelmäßig einen, ein Bedienmenü zur Steuerung und/oder Betätigung von Fahrzeugfunktionen, beispielsweise eines Infotainment-Systems oder eines Navigations-Systems des Fahrzeuges, anzeigenden Bildschirm auf. Ein derartiger Bildschirm ist dabei üblicherweise an einer Mittelkonsole des Fahrzeuges angeordnet, so dass ein Fahrer des Fahrzeuges den Bildschirm stets gut im Blick hat. Die Bedienung des Bedienmenüs kann dabei mittels einer Vielzahl unterschiedlicher Bedienelemente, beispielsweise Tasten, Drehknöpfen oder Scrollrädern, erfolgen. Als besonders vorteilhaftes Bedienelement hat sich ein sogenannter Dreh-Drück-Steller erwiesen, durch dessen Drehbewegung beispielsweise zwischen den einzelnen Menüpunkten des Bedienmenüs gescrollt bzw. ein Menüpunkt vorausgewählt werden kann und durch dessen Drückbetätigung der vorausgewählte Menüpunkt dann ausgewählt werden kann. Mittels des Dreh-Drück-Steller kann die Anzahl der Bedienelemente deutlich verringert werden. Zudem wird durch den Dreh-Drück-Steller eine besonders intuitive Bedienung des Bedienmenüs möglich, wodurch ein Fahrer des Fahrzeuges seinen Blick nicht auf den Dreh-Drück-Steller richten muss, um das Bedienmenü richtig zu bedienen.

Die Verwendung eines Dreh-Drück-Stellers zur Bedienung des Bedienmenüs hat jedoch den Nachteil, dass häufig eine äußerst aufwändige Bedienung über viele Einzelschritte notwendig ist, um die gewünschte Fahrzeugfunktion zu betätigen. Um dem entgegenzuwirken, werden regelmäßig sogenannte Direkt-Einstiegstasten verwendet, wobei mittels einer Direkt-Einstiegstaste jeweils ein wichtiger Hauptmenüpunkt des Bedienmenüs, beispielsweise Fahrzeugnavigation, Infotainment oder Medien, direkt ausgewählt werden kann. Die Direkt-Einstiegstasten sind dabei zumeist in unmittelbarer Umgebung des Dreh-Drück-Stellers angeordnet. Trotz dieser Anordnung hat eine große Anzahl an Direkt-Einstiegstasten gegebenenfalls eine Ablenkung des Fahrers vom Verkehrsgeschehen zur Folge.

Ein solches Bediensystem wird von dem Dokument DE 100 56 307 A1 gezeigt.

Aufgabe der Erfindung ist es, ein Bediensystem für Fahrzeug, insbesondere für ein Nutzfahrzeug, bereitzustellen, bei dem die Funktionalität und/oder die Bedienung erleichtert ist. Eine weitere Aufgabe ist es, ein Verfahren zur Betätigung eines derartigen Bedienmenüs vorzuschlagen.

Diese Aufgabe wird durch die Merkmale der unabhängigen Ansprüche gelöst. Bevorzugte Weiterbildungen sind in den Unteransprüchen offenbart.

Die Erfindung betrifft ein Bediensystem für ein Fahrzeug, insbesondere für ein Nutzfahrzeug, gemäß Anspruch 1.

Auf diese Weise wird die Bedienung des Bedienmenüs deutlich erleichtert, da, im Vergleich zu einer herkömmlichen Direkt-Einstiegstaste, mit dem drehbaren Direkt-Bedienelement mehrere Hauptmenüpunkte des Bedienmenüs direkt ausgewählt und/oder vorausgewählt werden können. So muss ein Nutzer des erfindungsgemäßen Bediensystems nicht erst nach der richtigen Direkt-Einstiegstaste suchen, um in den gewünschten Hauptmenüpunkt des Bedienmenüs zu gelangen. Vielmehr kann der Fahrer des Fahrzeuges das drehbare Direkt-Bedienelement intuitiv in die richtige Drehposition drehen, um den gewünschten Hauptmenüpunkt auszuwählen und/oder vorausauszuwählen. Da die Betätigung des drehbaren Direkt-Bedienelements zudem auch ähnlich der Betätigung des Dreh-Drück-Stellers ist, kann das Bedienmenü auf besonders einfache Weise bedient werden.

Des Weiteren kann auch die Anzahl der mittels des Direkt-Bedienelements auswählbaren und/oder vorauswählbaren Hauptmenüpunkte besonders einfach geändert bzw. variiert werden, da lediglich einer definierten Drehposition des Direkt-Bedienelements jeweils ein Hauptmenüpunkt des Bedienmenüs zugeordnet werden muss. Eine derartige Zuordnung könnte beispielsweise mit Hilfe des Bedienmenüs durchgeführt werden. Die Anzahl der auswählbaren und/oder vorauswählbaren Hauptmenüpunkte ist somit nicht von der Anzahl der vorgesehenen Direkt-Bedienelemente abhängig.

Bevorzugt sind dabei sowohl die das Bedienmenü anzeigende Anzeigeeinrichtung, der Dreh-Drück-Steller als auch das drehbare Direkt-Bedienelement ortsfest und/oder stationär an dem Fahrzeug angeordnet. Auf diese Weise kann das Bedienmenü besonders intuitiv bedient werden. Ebenso wäre es aber auch denkbar, dass der Dreh-Drück-Steller und/oder das drehbare Direkt-Bedienelement einer mobilen Fernbedienung zugeordnet sind. Dadurch könnte das Bedienmenü auf besonders flexible Weise bedient werden.

In einer bevorzugten Ausführungsform des erfindungsgemäßen Bediensystems können der Dreh-Drück-Steller und das Direkt-Bedienelement einander derart zugeordnet sein, dass das Direkt-Bedienelement und der Dreh-Drück-Steller mit einer Hand eines Nutzers des Bediensystems, insbesondere eines Fahrers des Fahrzeuges, betätigt und/oder berührt werden können, insbesondere im Wesentlichen gleichzeitig betätigt und/oder berührt werden können. Dadurch kann der Nutzer des Bediensystems das Direkt-Bedienelement besonders einfach auffinden, wenn er bereits in Berührkontakt mit dem Dreh-Drück-Steller ist. Ebenso kann auch der Dreh-Drück-Steller besonders einfach gefunden werden, wenn der Nutzer des Bediensystems das Direkt-Bedienelement berührt. Zudem kann durch eine derartige Zuordnung der Nutzer des Bediensystems den Dreh-Drück-Steller und das Direkt-Bedienelement in einer im Wesentlichen gleichen Handstellung drehbetätigen.

Vorzugsweise kann das Direkt-Bedienelement ringförmig, insbesondere kreisringförmig, als Einstellring ausgebildet sein. Auf diese Weise ist das Direkt-Bedienelement besonders einfach und ergonomisch günstig ausgebildet. Alternativ oder zusätzlich kann das Direkt-Bedienelement den Dreh-Drück-Steller zumindest bereichsweise konturangepasst und/oder mit einem definierten Spaltabstand umgreifen, insbesondere ringförmig umschließen. Auf diese Weise kann das erfindungsgemäße Bediensystem auch besonders kompakt und platzsparend für eine besonders einfache intuitive Bedienung ausgeführt werden.

Weiter bevorzugt kann das Direkt-Bedienelement konisch mit, in Hochachsenrichtung gesehen, nach oben verjüngenden Querschnitt ausgebildet sein. Vorzugsweise kann zudem der Dreh-Drück-Steller rotationssymmetrisch ausgebildet sein. Dadurch sind das ringförmige Direkt-Bedienelement und/oder der Dreh-Drück-Steller funktionsoptimiert und ergonomisch gestaltet. Bevorzugt kann der Dreh-Drück-Steller das Direkt-Bedienelement in Hochachsenrichtung gesehen, überragen. Beispielsweise kann der Dreh-Drück-Steller in der Art eines pilzkopfartigen Drehknopfes ausgebildet sein. Die Erhabenheit des Dreh-Druck-Stellers erlaubt auch bei nicht genauem Hinsehen des Nutzers eine funktionssichere Unterscheidung beider Elemente und hilft somit eine Fehlbedienung zu vermeiden bzw. die Bediensicherheit zu erhöhen.

Vorzugsweise können eine Drehachse des Direkt-Bedienelements und eine Drehachse des Dreh-Drück-Stellers richtungsgleich ausgerichtet sein, wobei bevorzugt vorgesehen ist, dass die Drehachse des Direkt-Bedienelements, in Radialrichtung gesehen, innerhalb einer, insbesondere kreisförmigen, radialen Außenkontur des Dreh-Drück-Stellers angeordnet ist. Alternativ oder zusätzlich können die Drehachsen des Direkt-Bedienelements und die Drehachse des Dreh-Drück-Stellers zueinander kongruent sein. Auf diese Weise kann das erfindungsgemäße Bediensystem noch kompakter ausgeführt und noch einfacher bedient werden.

Weiter bevorzugt kann eine Außenwand des Direkt-Bedienelements eine Anti-Rutsch-Struktur aufweisen, mittels der bei einer Betätigung des Direkt-Bedienelements ein Abrutschen von dem Direkt-Bedienelement verhindert und/oder erschwert ist. Mittels einer derartigen Anti-Rutsch-Struktur wird die Betätigung des Direkt-Bedienelements deutlich erleichtert. Alternativ und/oder zusätzlich kann auch eine Struktur vorgesehen sein, mittels der das Greifen des Direkt-Bedienelements mit den Fingern ergonomisch unterstützt ist. Hierzu kann die beispielsweise mit geeigneten Ausnehmungen und/oder Erhebungen ausgebildet sein.

In einer bevorzugten Ausführungsform kann wenigstens ein Begrenzungs- und/oder Anschlagelement vorgesehen sein, mittels dem die Verdrehung des Direkt-Bedienelements in wenigstens eine Drehrichtung derart begrenzt werden kann, dass das Direkt-Bedienelement bis hin zu einer definierten Anschlagposition gedreht werden kann. Dadurch kann einem Nutzer des Direkt-Bedienelements zuverlässig mitgeteilt werden, wie weit das Direkt-Bedienelement gedreht werden kann bzw. bis hin zu welcher Drehposition die Drehung des Direkt-Bedienelements sinnvoll ist. Vorzugsweise kann dabei der definierten Anschlagposition ein Hauptmenüpunkt des Bedienmenüs zugeordnet sein, so dass dieser Hauptmenüpunkt ausgewählt und/oder vorausgewählt wird, wenn sich das Direkt-Bedienelement in der Anschlagposition befindet. Besonders bevorzugt kann das Begrenzungs- und/oder Anschlagelement weiter derart ausgebildet sein, dass die wenigstens eine Anschlagposition verstellt und/oder eingestellt werden kann. Auf diese Weise ist das Begrenzungs- und/oder Anschlagelement besonders flexibel ausgebildet. Alternativ kann auch auf das wenigstens eine Begrenzungs- und/oder Anschlagelement verzichtet werden, wobei in diesem Fall bevorzugt vorgesehen ist, dass die Hauptmenüpunkte mittels des Direkt-Bedienelements wiederholt durchgewählt werden können.

Konkret ist das erfindungsgemäße Bediensystem derart ausgebildet, dass jeder der direkt auswählbaren und/oder vorauswählbaren Menüpunkte jeweils einer definierten Drehposition des Direkt-Bedienelements zugeordnet ist, wobei durch Drehen des Direkt-Bedienelements in eine der definierten Drehpositionen der der Drehposition zugeordnete Hauptmenüpunkt direkt ausgewählt und/oder vorausgewählt werden kann. Dadurch kann das Bedienmenü der Anzeigeeinrichtung zuverlässig und funktionssicher bedient werden. Besonders bevorzugt kann vorgesehen sein , dass das Bediensystem derart ausgebildet ist, dass die Zuordnung der Hauptmenüpunkte zu den definierten Drehpositionen verstellt und/oder eingestellt werden kann. Auf diese Weise kann die Zuordnung der Hauptmenüpunkte zu den definierten Drehpositionen an die individuellen Bedürfnisse eines Nutzers des Direkt-Bedienelements angepasst werden. Zudem ist es beispielsweise möglich, bei einem An-Aus-An Zyklus der Fahrzeug-Zündung die Zuordnung der Hauptmenüpunkte zu den definierten Drehpositionen derart einzustellen und/oder zu verstellen, dass eine definierte Ausgangsstellung des Direkt-Bedienelements eingestellt wird, ohne dass das Direkt-Bedienelement in die Ausgangsstellung gedreht werden muss.

Erfindungsgemäss ist eine Zuordnungs-Anzeigeeinrichtung vorgesehen, mittels der einem Nutzer des Direkt-Bedienelements die Zuordnung der Hauptmenüpunkte zu den definierten Drehposition des Direkt-Bedienelements (zum Beispiel visuell) angezeigt wird. Mittels einer derartigen Zuordnungs-Anzeigeeinrichtung wird die Bedienung des Bedienmenüs deutlich vereinfacht. Alternativ und/oder zusätzlich kann eine Funktions-Anzeigeeinrichtung vorgesehen sein, mittels der einem Nutzer des Direkt-Bedienelements und/oder des Dreh-Drück-Stellers, insbesondere visuell, angezeigt werden kann, ob das Direkt-Bedienelement und/oder der Dreh-Drück-Steller funktionsfähig und/oder, insbesondere im aktuellen Menüpunkt des Bedienmenüs, verwendet werden kann. So kann dem Nutzer beispielsweise angezeigt werden, ob das Direkt-Bedienelement und/oder der Dreh-Drück-Steller in dem Menüpunkt des Bedienmenüs, in dem sich der Nutzer aktuell befindet, auch verwendet werden kann. Die Anzeige über die Funktionsfähigkeit und/oder die Verwendbarkeit des Direkt-Bedienelements und/oder des Dreh-Drück-Stellers kann dabei bespielsweise durch partielle Hinterleuchtung des Direkt-Bedienelements und/oder des Dreh-Drück-Stellers erfolgen.

Weiter bevorzugt kann die Zuordnungs-Anzeigeeinrichtung wenigstens ein, vorzugsweise fahrzeugseitig angeordnetes, Anzeigeelement, insbesondere ein Leuchtelement, aufweisen, mittels dem der ausgewählte und/oder vorausgewählte Hauptmenüpunkt angezeigt werden kann. Auf diese Weise kann dem Nutzer des Direkt-Bedienelements die aktuelle Drehposition des Direkt-Bedienelements zuverlässig und einfach mitgeteilt werden. Besonders bevorzugt kann die Zuordnungs-Anzeigeeinrichtung derart ausgebildet sein, dass die mittels dieser angezeigte Zuordnung der Hauptmenüpunkte zu den definierten Drehpositionen des Direkt-Bedienelements eingestellt und/oder verstellt werden kann. Dadurch kann die Zuordnung der Hauptmenüpunkte zu den definierten Drehpositionen an die individuellen Bedürfnisse eines Nutzers des Direkt-Bedienelements angepasst werden. Alternativ wäre es aber auch denkbar, dass die mittels der Zuordnungs-Anzeigeeinrichtung angezeigte Zuordnung der Hauptmenüpunkte zu den definierten Drehpositionen nicht einstellbar und/oder verstellbar ist, wodurch die Hauptmenüpunkte dann fest mit den definierten Drehpositionen des Direkt-Bedienelements gekoppelt wären.

Bevorzugt kann die Zuordnungs-Anzeigeeinrichtung auch die Bedienmenü-Anzeigeeinrichtung, insbesondere ein Bildschirm, sein, um die Bedienung des Bedienmenüs weiter zu vereinfachen. Alternativ oder zusätzlich kann die Zuordnungs-Anzeigeeinrichtung in Hochachsenrichtung gesehen unterhalb der Bedienmenü-Anzeigeeinrichtung angeordnet sein. Weiter bevorzugt können das Direkt-Bedienelement und/oder der Dreh-Drück-Steller und/oder die Zuordnungs-Anzeigeeinrichtung an einem Funktionsteil des Fahrzeugs und/oder an einer Konsole, insbesondere an einer Instrumententafel und/oder an einer Mittelkonsole, des Fahrzeuges angeordnet sein.

In einer weiteren bevorzugten Ausführungsform kann eine Feedback-Einrichtung vorgesehen sein, mittels der ein optisches und/oder akustisches und/oder haptisches Signals als Feedback an einen Nutzer des Direkt-Bedienelements ausgegeben werden kann, wenn dieser das Direkt-Bedienelement betätigt. Auf diese Weise kann der Nutzer des Direkt-Bedienelements zuverlässig darüber informiert werden, ob seine Betätigung des Direkt-Bedienelements erfolgreich war. In einer bevorzugten Ausführung kann das Direkt-Bedienelement in n-Drehschritten drehbetätigbar sein, wobei den einzelnen Drehschritten des Direkt-Bedienelements jeweils ein Hauptmenüpunkt zugeordnet ist. Die Feedback-Einrichtung kann dann vorzugsweise derart ausgebildet sein, dass bei jedem Drehschritt ein optisches und/oder akustisches und/oder haptisches Feedback an den Nutzer des Direkt-Bedienelements ausgegeben wird, wenn er das Direkt-Bedienelement um einen Drehschritt dreht. Insbesondere das haptische Feedback kann dabei in der Art eines Ein- und Ausrastsystems gestaltet sein.

Erfindungsgemäss ist zudem eine Sensor- und/oder Erfassungseinrichtung vorgesehen, mittels der eine Annäherung einer Nutzer-Hand an das Direkt-Bedienelement erfasst und/oder erkannt werden kann. Dadurch ist es beispielsweise möglich, dass die Betätigung des Direkt-Bedienelements erst dann freigegeben wird, wenn die Annäherung der Nutzer-Hand erfasst und/oder erkannt wird. Besonders bevorzugt kann die Sensor- und/oder Erfassungseinrichtung signaltechnisch mit der Zuordnungs-Anzeigeeinrichtung verbunden sein. Dadurch kann beispielsweise die Zuordnungs-Anzeige bzw. Anzeige der Hauptmenüpunkte erst dann angezeigt werden, wenn sich die Nutzer-Hand an das Direkt-Bedienelement annähert und/oder in einem definiert vorgegebenen Nahbereich befindet. Ebenso kann auch vorgesehen sein (alternativ oder zusätzlich), dass die Anzeige der Zuordnungs-Anzeigeeinrichtung vergrößert oder anderweitig hervorgehoben wird, wenn sich eine Nutzer-Hand an das Direkt-Bedienelement annähert und/oder in einem definiert vorgegebenen Nahbereich befindet.

Zur Lösung der bereits erläuterten Aufgabenstellung wird ferner ein Verfahren zur Bedienung eines Bedienmenüs eines Fahrzeuges gemäss Anspruch 13 vorgeschlagen.

Ferner wird ein Fahrzeug, insbesondere ein Nutzfahrzeug, mit dem erfindungsgemäßen Bediensystem beansprucht. Auch die sich aus der erfindungsgemäßen Verfahrensführung ergebenden Vorteile sind identisch mit den bereits gewürdigten Vorteilen des erfindungsgemäßen Bediensystems, so dass auch diese hier nicht wiederholt werden.

Die vorstehend erläuterten und/oder in den Unteransprüchen wiedergegebenen vorteilhaften Aus- und/oder Weiterbildungen der Erfindung können- außer zum Beispiel in den Fällen eindeutiger Abhängigkeiten oder unvereinbarer Alternativen - einzeln oder aber auch in beliebiger Kombination miteinander zur Anwendung kommen.

Die Erfindung und ihre vorteilhaften Aus- und/oder Weiterbildungen sowie deren Vorteile werden nachfolgend anhand von Zeichnungen lediglich beispielhaft näher erläutert.

Es zeigen:
- Fig. 1: in einer Perspektivdarstellung einen Teil einer Fahrerkabine eines Lastkraftwagens mit dem erfindungsgemäßen Bediensystem;
- Fig. 2: in einer Perspektivdarstellung ein vorderer Bereich einer Armlehne des Lastkraftwagens; und
- Fig. 3: der vordere Bereich der Armlehne in Draufsicht.

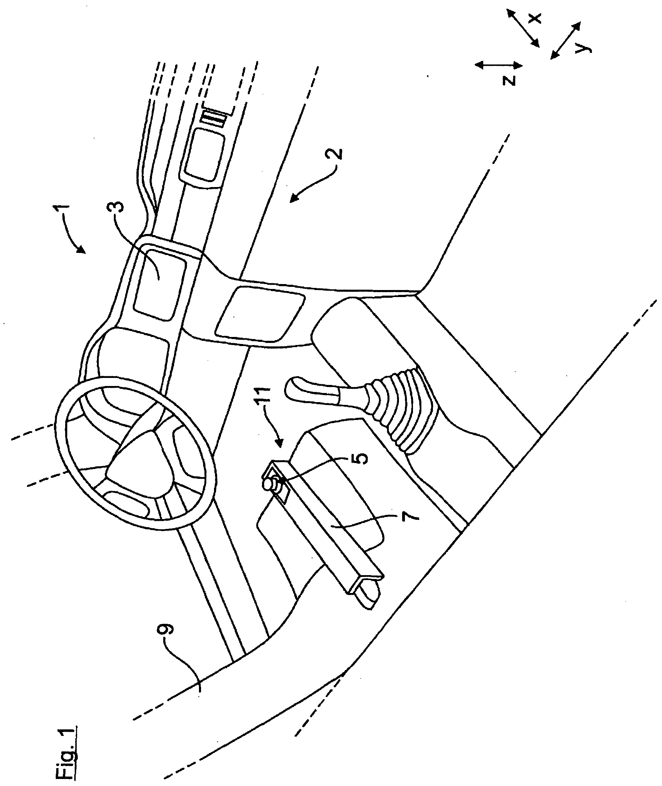

In Fig. 1 ist schematisch ein Fahrerhaus 1 eines Lastkraftwagens von innen gezeigt. Das Fahrerhaus 1 weist einen ein Bedienmenü zur Steuerung und/oder Betätigung verschiedener Fahrzeugfunktionen, beispielsweise eines Infotainment-Systems oder eines Navigationssystems des Fahrzeuges, anzeigenden Bildschirm 3 auf. Der Bildschirm 3 ist hier beispielhaft einer Instrumententafel 2 des Lastkraftwagens zugeordnet und mit einer hier mit gestrichelten Linien angedeuteten erfindungsgemäßen Betätigungseinrichtung 5 des Lastkraftwagens signaltechnisch gekoppelt. Die signaltechnische Kopplung ist dabei derart ausgebildet, dass das Bedienmenü des Bildschirms 3 mit der Betätigungseinrichtung 5 bedient werden kann. Weiter ist, hier lediglich beispielhaft, die Betätigungseinrichtung 5 ortsfest an einer rechten Armlehne 7 als beispielhaftes Funktionsteil eines Fahrzeugsitzes 9 des Lastkraftwagens festgelegt und an einem, in Fahrzeug-Längsrichtung x gesehen, vorderen Bereich 11 der Armlehne 7, in Fahrzeug-Hochrichtung z gesehen, oberseitig an der Armlehne 7 angeordnet. Durch diese Anordnung kann ein Fahrer des Lastkraftwagens, insbesondere auch während einer Fahrt mit dem Lastkraftwagen, die Betätigungseinrichtung 5 auf komfortable Weise betätigen.

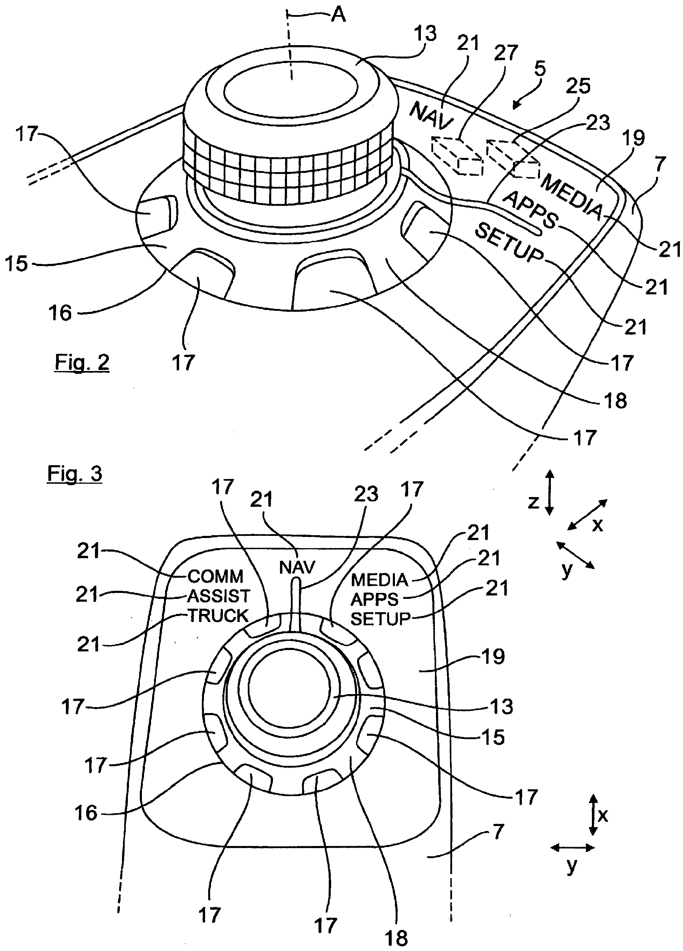

In Fig. 2 ist der vordere Bereich 11 der Armlehne 7 detaillierter gezeigt. Die hier angeordnete Betätigungseinrichtung 5 weist einen dreh- und drückbaren Dreh-Drück-Steller 13 auf, durch dessen Dreh- und Drückbetätigung das Bedienmenü des Bildschirms 3 bedient werden kann. Die Drehbetätigung des Dreh-Drück-Stellers 13 ermöglicht dabei beispielsweise ein Scrollen zwischen Menüpunkten des Bedienmenüs bzw. eine Vorauswahl eines Menüpunktes. Der vorausgewählte Menüpunkt kann dann beispielsweise durch Druckbetätigung des Dreh-Drück-Stellers 13 ausgewählt werden. Auf diese Weise ist es möglich, das gesamte Bedienmenü mit dem Dreh-Drück-Steller 13 zu bedienen.

Wie aus Fig. 2 hervorgeht, ist der Dreh-Drück-Steller 13 um eine, hier lediglich beispielhaft, in Fahrzeug-Hochrichtung z ausgerichtete zentrale Drehachse A drehbar an dem vorderen Bereich 11 der Armlehne 7 festgelegt. Der hier beispielhaft pilzkopfartig ausgebildete Dreh-Drück-Steller 13 steht dabei, in Fahrzeug-Hochrichtung z gesehen, nach oben von dem vorderen Bereich 11 der Armlehne 7 ab, wodurch er, beispielsweise mit einer auf die Armlehne 7 aufgelegten Hand, auf einfache Weise betätigt werden kann. Des Weiteren ist der Dreh-Drück-Steller 13 rotationssymmetrisch um die Drehachse A ausgebildet und kann druckbetätigt werden, indem er entlang der Drehachse A, in Fahrzeug-Hochrichtung z gesehen, nach unten gedrückt wird.

Wie in Fig. 2 weiter gezeigt ist, weist die Betätigungseinrichtung 5 ein kreisringförmiges Direkt-Bedienelement 15 als Einstellring auf. Mittels des Direkt-Bedienelements 15 ist es möglich, mehrere unterschiedliche Hauptmenüpunkte des Bedienmenüs, beispielsweise Fahrzeugnavigation oder Infotainment, direkt vorauszuwählen und/oder auszuwählen. Mittels des Dreh-Drück-Stellers 13 kann dann der direkt vorausgewählte Hauptmenüpunkt durch Drückbetätigung des Dreh-Drück-Stellers 13 ausgewählt und/oder nach Auswahl eines Hauptmenüpunktes ein Untermenüpunkt im ausgewählten Hauptmenüpunkt ausgewählt werden. Auf diese Weise kann das Bedienmenü besonders rasch und einfach bedient werden. Die mittels des Direkt-Bedienelements 15 auswählbaren und/oder vorauswählbaren Hauptmenüpunkte sind dabei jeweils einer definierten Drehposition des Direkt-Bedienelements 15 zugeordnet, so dass durch Drehen des Direkt-Bedienelements 15 in eine definierte Drehposition der der Drehposition zugeordnete Hauptmenüpunkt direkt ausgewählt und/oder vorausgewählt werden kann. Bevorzugt kann zudem vorgesehen sein, dass die Zuordnung der Hauptmenüpunkte zu der definierten Drehposition und/oder die Anzahl der auswählbaren und/oder vorauswählbaren Hauptmenüpunkte individuell eingestellt werden kann.

Gemäß Fig. 2 umgibt das als Einstellring ausgebildete Direkt-Bedienelement 15 hier lediglich beispielhaft einen, in Fahrzeug-Hochrichtung z gesehen, unteren Bereich des Dreh-Drück-Stellers 13 konturangepasst bzw. mit einem definierten Spaltabstand und ist dieser, ebenso wie auch der Dreh-Drück-Steller 13, drehbar um die Drehachse A an dem vorderen Bereich 11 der Armlehne 7 festgelegt. Das Direkt-Bedienelement 15 ist, hier lediglich beispielhaft, weiter derart angeordnet, dass die Drehachse A zentral durch das das Direkt-Bedienelement 15 verläuft. Die Drehachse A verläuft hier daher, in Radialrichtung gesehen, innerhalb einer kreisförmigen Außenkontur 16 des Direkt-Bedienelements 15. Durch diese Anordnung des Direkt-Bedienelement 15 ist es möglich, den Dreh-Drück-Steller 13 und das Direkt-Bedienelement 15 gleichzeitig mit einer Hand und mit einer ähnlichen Handstellung zu betätigen. Dadurch können der Dreh-Drück-Steller 13 und das Direkt-Bedienelement 15 besonders einfach und intuitiv betätigt werden.

Des Weiteren ist das Direkt-Bedienelement 15, hier beispielhaft, konisch mit, in Fahrzeug-Hochrichtung z gesehen, nach oben verjüngendem Querschnitt ausgebildet. Zudem weist eine radial äußere Wandung 18 des Direkt-Bedienelements 15 hier eine mittels Ausnehmungen 17 ausgebildete Anti-Rutsch-Struktur auf.

Wie aus den Fig. 2 und 3 hervorgeht, weist der vordere Bereich 11 der Armlehne 7, in Fahrzeug-Hochrichtung z gesehen, oberseitig einen Anzeige- und/oder Bildschirmbereich 19 auf. Mittels des Anzeige- und/oder Bildschirmbereichs 19 wird dem Nutzer des Direkt-Bedienelements 15 die Zuordnung der auswählbaren und/oder vorauswählbaren Hauptmenüpunkte des Bedienmenüs zu den definierten Drehpositionen des Direkt-Bedienelements 15 hier visuell angezeigt und somit eine einfache und gezielte Betätigung des Direkt-Bedienelements 15 ermöglicht. Die Zuordnung der Hauptmenüpunkte zu den definierten Drehpositionen des Direkt-Bedienelements wird beispielhaft gemäß Fig. 3 dadurch ersichtlich, dass an dem Bildschirm 19 Bezeichnungen 21 der einzelnen Hauptmenüpunkte angezeigt werden. Die Bezeichnungen 21 der Hauptmenüpunkte sind dabei derart um das Direkt-Bedienelement 15 herum angeordnet, dass bei einer Drehbetätigung des Direkt-Bedienelements 15 in Richtung einer der Bezeichnungen 21 der zu dieser Bezeichnung 21 korrespondierende Hauptmenüpunkt ausgewählt und/oder vorausgewählt wird. Der durch das Direkt-Bedienelement 15 ausgewählte und/oder vorausgewählte Hauptmenüpunkt wird dabei, hier lediglich beispielhaft, mittels Leuchtelementen 23 des Bildschirms 19 angezeigt. In den Fig. 2 und 3 ist jeweils ein anderer Hauptmenüpunkt ausgewählt und/oder vorausgewählt, wodurch hier unterschiedlich angeordnete Leuchtelemente 23 aktiviert sind. In einer bevorzugten Ausführung kann zudem die mittels des Bildschirms 19 angezeigte Zuordnung der Hauptmenüpunkte zu den definierten Drehpositionen des Direkt-Bedienelements 15 auch eingestellt und/oder verstellt werden, um die angezeigte Zuordnung individuell anzupassen.

Des Weiteren kann optional auch eine in Fig. 2 lediglich mit gestrichelten Linien angedeutete Feedback-Einrichtung 25 vorgesehen sein, mittels der ein optisches und/oder akustisches und/oder haptisches Signal als Feedback an einen Nutzer des Direkt-Bedienelements 15 ausgegeben werden kann, wenn dieser das Direkt-Bedienelement 15 betätigt. Optional kann zudem auch eine in Fig. 2 ebenfalls mit gestrichelten Linien angedeutete Sensor- und/oder Erfassungseinrichtung 27 vorgesehen sein, mittels der eine Annäherung einer Nutzer-Hand an das Direkt-Bedienelement 15 erfasst und/oder erkannt werden kann. Bevorzugt kann eine derartige Sensor- und/oder Erfassungseinrichtung signaltechnisch mit dem Bildschirm 19 verbunden sein. Dadurch kann beispielsweise die Anzeige des Bildschirms 19 erst dann aktiviert werden, wenn eine Annäherung der Nutzer-Hand an das Direkt-Bedienelement 15 erfasst und/oder erkannt wird. Ebenso könnte beispielsweise auch die Anzeige des Bildschirms 19 vergrößert werden, wenn eine Annäherung der Nutzer-Hand an das Direkt-Bedienelement 15 erfasst und/oder erkannt wird.

Weiter optional kann auch ein in den Figuren nicht gezeigtes Begrenzungs- und/oder Anschlagelement vorgesehen sein, mittels dem die Drehung des drehbaren Direkt-Bedienelements 15 in wenigstens eine Drehrichtung derart begrenzt werden kann, dass das Direkt-Bedienelement 15 bis hin zu einer definierten Anschlagposition gedreht werden kann. Besonders bevorzugt kann das Begrenzungs- und/oder Anschlagelement derart ausgebildet sein, dass die wenigstens eine Anschlagposition verstellt und/oder eingestellt werden kann.

### Bezugszeichen

1 Fahrerhaus
2 Instrumententafel
3 Bildschirm
5 Betätigungseinrichtung
7 Armlehne
9 Fahrzeugsitz
11 vorderer Bereich
13 Dreh-Drück-Steller
15 Direkt-Bedienelement
16 Außenkontur
17 Ausnehmung
18 äußere Wandung
19 Anzeige- und/oder Bildschirmbereich
21 Bezeichnung
23 Leuchtelement
25 Feedback-Einrichtung
27 Sensor- und/oder Erfassungseinrichtung
A Drehachse

## Patentansprüche

1. Bediensystem für ein Fahrzeug, insbesondere für ein Nutzfahrzeug, mit wenigstens einer ein Bedienmenü zur Steuerung und/oder Betätigung von Fahrzeugfunktionen anzeigenden Anzeigeeinrichtung (3), insbesondere einem Bildschirm, und mit einem dreh- und drückbaren Dreh-Drück-Steller (13), durch dessen Dreh- und Drückbetätigung das Bedienmenü bedienbar ist, wobei dem Dreh-Drück-Steller (13) ein drehbares Direkt-Bedienelement (15) zugeordnet ist, durch dessen Drehbetätigung mehrere unterschiedliche Hauptmenüpunkte des Bedienmenüs direkt auswählbar und/oder vorauswählbar sind, wobei mittels des Dreh-Drück-Stellers (13) der vorausgewählte Hauptmenüpunkt und/oder wenigstens ein Untermenüpunkt im ausgewählten Hauptmenüpunkt auswählbar ist,
**dadurch gekennzeichnet, dass**
das Bediensystem derart ausgebildet ist, dass jeder der direkt auswählbaren und/oder vorauswählbaren Hauptmenüpunkte jeweils einer definierten Drehposition des Direkt-Bedienelements (15) zugeordnet ist, wobei durch Drehen des Direkt-Bedienelements (15) in eine der definierten Drehposition der der Drehposition zugeordnete Hauptmenüpunkt direkt auswählbar und/oder vorauswählbar ist, und dass das Bediensystem derart ausgebildet ist, dass die Zuordnung der Hauptmenüpunkte zu den definierten Drehpositionen verstellbar und/oder einstellbar ist,
dass eine Zuordnungs-Anzeigeeinrichtung (19) vorgesehen ist, mittels der einem Nutzer des Direkt-Bedienelements (15) die Zuordnung der Hauptmenüpunkte zu den definierten Drehpositionen des Direkt-Bedienelements (15) anzeigbar ist,
dass eine Sensor- und/oder Erfassungseinrichtung (27) vorgesehen ist, mittels der eine Annäherung einer Nutzer-Hand an das Direkt-Bedienelement (15) erfassbar und/oder erkennbar ist und dass die Sensor- und/oder Erfassungseinrichtung (27) signaltechnisch mit der Zuordnungs-Anzeigeeinrichtung (19) verbunden ist.

2. Bediensystem nach Anspruch 1, **dadurch gekennzeichnet, dass** der Dreh-Drück-Steller (13) und das Direkt-Bedienelement (15) einander derart zugeordnet sind, dass das Direkt-Bedienelement (15) und der Dreh-Drück-Steller (13) mit einer Hand eines Nutzers des Bediensystems, insbesondere eines Fahrer des Fahrzeuges, betätigbar sind, insbesondere gleichzeitig betätigbar sind.

3. Bediensystem nach Anspruch 1 oder 2, **dadurch gekennzeichnet, dass** das Direkt-Bedienelement (15) ringförmig, insbesondere kreisringförmig, als Einstellring ausgebildet ist und/oder dass das Direkt-Bedienelement (15) den Dreh-Drück-Steller (13) zumindest bereichsweise konturangepasst und/oder mit einem definierten Spaltabstand umgreift, insbesondere ringförmig umschließt.

4. Bediensystem nach einem der vorhergehenden Ansprüche, **dadurch gekennzeichnet, dass** das Direkt-Bedienelement (15) konisch mit, in Hochachsenrichtung (z) gesehen, nach oben verjüngendem Querschnitt ausgebildet ist, und/oder dass der, vorzugsweise in der Art eines pilzkopfartigen Drehknopfes ausgebildete, Dreh-Drück-Steller (13) das Direkt-Bedienelement (15) in Hochachsenrichtung (z) überragt, und/oder dass der Dreh-Drück-Steller (13) rotationssymmetrisch ausgebildet ist.

5. Bediensystem nach einem der vorhergehenden Ansprüche, **dadurch gekennzeichnet, dass** eine Drehachse (A) des Direkt-Bedienelements (15) und eine Drehachse (A) des Dreh-Drück-Stellers (13) richtungsgleich ausgerichtet sind, wobei bevorzugt vorgesehen ist, dass die Drehachse (A) des Direkt-Bedienelements (A), in Radialrichtung gesehen, innerhalb einer, insbesondere kreisförmigen, radialen Außenkontur (16) des Dreh-Drück-Stellers (13) angeordnet ist und/oder dass die Drehachse (A) des Direkt-Bedienelements (15) und die Drehachse (A) des Dreh-Drück-Stellers (13) zueinander kongruent angeordnet sind.

6. Bediensystem nach einem der vorhergehenden Ansprüche, **dadurch gekennzeichnet, dass** eine Außenwand (18) des Direkt-Bedienelements (15) eine Anti-Rutsch-Struktur aufweist, mittels der bei einer Betätigung des Direkt-Bedienelements (15) ein Abrutschen von dem Direkt-Bedienelement (15) verhindert und/oder erschwert ist, und/oder dass die Außenwand (18) eine Struktur aufweist, mittels der das Greifen des Direkt-Bedienelements (15) mit den Fingern ergonomisch unterstützt ist.

7. Bediensystem nach einem der vorhergehenden Ansprüche, **dadurch gekennzeichnet, dass** wenigstens ein Begrenzungs- und/oder Anschlagelement vorgesehen ist, mittels dem eine Verdrehung des Direkt-Bedienelements (15) in wenigstens eine Drehrichtung derart begrenzbar ist, dass das Direkt-Bedienelement (15) bis hin zu einer definierten Anschlagposition drehbar ist, wobei bevorzugt vorgesehen ist, dass das Begrenzungs- und/oder Anschlagelement derart ausgebildet ist, dass die wenigstens eine Anschlagposition verstellbar und/oder einstellbar ist.

8. Bediensystem nach einem der vorhergehenden Ansprüchen, **dadurch gekennzeichnet, dass** eine Funktions-Anzeigeeinrichtung vorgesehen ist, mittels der einem Nutzer des Direkt-Bedienelements (15) und/oder des Dreh-Drück-Stellers (13), insbesondere visuell, anzeigbar ist, ob das Direkt-Bedienelement (15) und/oder der Dreh-Drück-Steller (13) funktionsfähig und/oder, insbesondere im aktuellen Menüpunkt des Bedienmenüs, verwendbar ist.

9. Bediensystem nach einem der vorhergehenden Ansprüche, **dadurch gekennzeichnet, dass** die Zuordnungs-Anzeigeeinrichtung (19) wenigstens ein, vorzugsweise fahrzeugseitig angeordnetes, Anzeigeelement (23), insbesondere ein fahrzeugseitig angeordnetes Leuchtelement, aufweist, mittels dem der ausgewählte und/oder vorausgewählte Menüpunkt anzeigbar ist, und/oder dass die Zuordnungs-Anzeigeeinrichtung (19) derart ausgebildet ist, dass die angezeigte Zuordnung der Hauptmenüpunkte zu den definierten Drehpositionen des Direkt-Bedienelements (15) einstellbar und/oder verstellbar ist.

10. Bediensystem nach einem der vorhergehenden Ansprüche, **dadurch gekennzeichnet, dass** die Zuordnungs-Anzeigeeinrichtung (19) die Bedienmenü-Anzeigeeinrichtung (3), insbesondere ein Bildschirm, ist und/oder in Hochachsenrichtung gesehen unterhalb Bedienmenü-Anzeigeeinrichtung (3) angeordnet ist.

11. Bediensystem nach einem der vorhergehenden Ansprüche, **dadurch gekennzeichnet, dass** das Direkt-Bedienelement (15) und/oder der Dreh-Drück-Steller (13) und/oder die Zuordnungs-Anzeigeeinrichtung (19) an einem Funktionsteil des Fahrzeuges und/oder an einer Konsole (2), insbesondere an einer Instrumententafel und/oder an einer Mittelkonsole, des Fahrzeuges angeordnet ist.

12. Bediensystem nach einem der vorhergehenden Ansprüche, **dadurch gekennzeichnet, dass** eine Feedback-Einrichtung (25) vorgesehen ist, mittels der ein optisches und/oder akustisches und/oder haptisches Signal als Feedback an einen Nutzer des Direkt-Bedienelements (15) ausgebbar ist, wenn dieser das Direkt-Bedienelement (15) betätigt oder betätigt hat.

13. Verfahren zur Betätigung eines Bedienmenüs eines Fahrzeuges, insbesondere eines Nutzfahrzeuges, mit wenigstens einer das Bedienmenü zur Steuerung und/oder Betätigung von Fahrzeugfunktionen anzeigenden Anzeigeeinrichtung (3), insbesondere einem Bildschirm, und mit einem dreh- und drückbaren Dreh-Drück-Steller (13), durch dessen Dreh- und Drückbetätigung das Bedienmenü bedient wird, wobei dem Dreh-Drück-Steller (13) ein drehbares Direkt-Bedienelement (15) zugeordnet ist, durch dessen Drehbetätigung einer von mehreren unterschiedlichen Hauptmenüpunkten des Bedienmenüs direkt ausgewählt und/oder vorausgewählt wird, wobei anschließend mittels des Dreh-Drück-Stellers (13) der vorausgewählte Hauptmenüpunkt und/oder wenigstens ein Untermenüpunkt im ausgewählten Hauptmenüpunkt ausgewählt wird,
**dadurch gekennzeichnet, dass**
das Bediensystem derart ausgebildet ist, dass jeder der direkt auswählbaren und/oder vorauswählbaren Hauptmenüpunkte jeweils einer definierten Drehposition des Direkt-Bedienelements (15) zugeordnet ist, wobei durch Drehen des Direkt-Bedienelements (15) in eine der definierten Drehposition der der Drehposition zugeordnete Hauptmenüpunkt direkt ausgewählt und/oder vorausgewählt wird, und dass das Bediensystem derart ausgebildet ist, dass die Zuordnung der Hauptmenüpunkte zu den definierten Drehpositionen verstellbar und/oder einstellbar ist,
dass eine Zuordnungs-Anzeigeeinrichtung (19) vorgesehen ist, mittels der einem Nutzer des Direkt-Bedienelements (15) die Zuordnung der Hauptmenüpunkte zu den definierten Drehpositionen des Direkt-Bedienelements (15) angezeigt wird,
dass eine Sensor- und/oder Erfassungseinrichtung (27) vorgesehen ist, mittels der eine Annäherung einer Nutzer-Hand an das Direkt-Bedienelement (15) erfasst und/oder erkannt wird und
dass die Sensor- und/oder Erfassungseinrichtung (27) derart signaltechnisch mit der Zuordnungs-Anzeigeeinrichtung (19) verbunden ist, dass die Zuordnungs-Anzeige der Hauptmenüpunkte vergrößert und/oder hervorgehoben wird und/oder die Zuordnungs-Anzeige erst dann angezeigt wird, wenn sich die Nutzer-Hand an das Direkt-Bedienelement annähert und/oder in einem definiert vorgegebenen Nahbereich befindet.

14. Fahrzeug, insbesondere Nutzfahrzeug, mit einem Bediensystem nach einem der Ansprüche 1 bis 12.

## Claims

1. Operator control system for a vehicle, in particular for a utility vehicle, having at least one display device (3), in particular a screen, which displays an operator control menu for controlling and/or activating vehicle functions, and having a rotatable and pressable turn-and-push controller (13), the rotational and pressure activation of which makes it possible to operate the operator control menu, wherein a rotatable direct operator control element (15) is assigned to the turn-and-push controller (13) and its rotational activation permits a plurality of different main menu items of the operator control menu to be selected and/or pre-selected directly, wherein the pre-selected main menu item and/or at least one sub-menu item in the selected main menu item can be selected by means of the turn-and-push controller (13),
**characterized in that**
the operator control system is embodied in such a way that each of the directly selectable and/or pre-selectable main menu items is assigned in each case to a defined rotational position of the direct operator control element (15), wherein, by rotating the direct operator control element (15) into one of the defined rotational positions, the main menu item which is assigned to the rotational position can be selected and/or pre-selected directly, and **in that** the operator control system is embodied in such a way that the assignment of the main menu items to the defined rotational positions can be adjusted and/or set,
**in that** an assignment display device (19) is provided, by means of which the assignment of the main menu items to the defined rotational positions of the direct operator control element (15) can be displayed to a user of the direct operator control element (15),
**in that** a sensor device and/or sensing device (27) is provided, by means of which it is possible to sense and/or detect a user's hand approaching the direct operator control element (15), and **in that** the sensor device and/or sensing device (27) is connected in a signal-transmitting fashion to the assignment display device (19).

2. Operator control system according to Claim 1, **characterized in that** the turn-and-push controller (13) and the direct operator control element (15) are directly assigned to one another in such a way that the direct operator control element (15) and the turn-and-push controller (13) can be activated, in particular can be activated simultaneously, with one hand of a user of the operator control system, in particular of a driver of the vehicle.

3. Operator control system according to Claim 1 or 2, **characterized in that** the direct operator control element (15) is embodied in a ring shape, in particular in a circularring shape, as an adjustment ring, and/or **in that** the direct operator control element (15) engages around the turn-and-push controller (13) in such a way that it is matched to the contour at least in certain areas and/or with a defined clearance, in particular encloses said turn-and-push controller (13) in a ring-shaped fashion.

4. Operator control system according to one of the preceding claims, **characterized in that** the direct operator control element (15) is embodied conically with a cross section which tapers upwards when viewed in the direction of the vertical axis (z), and/or **in that** the turn-and-push controller (13), which is preferably embodied in the manner of a mushroom-head-like rotary knob, projects beyond the direct operator control element (15) in the direction of the vertical axis (z), and/or **in that** the turn-and-push controller (13) is embodied in a rotationally symmetrical fashion.

5. Operator control system according to one of the preceding claims, **characterized in that** a rotational axis (A) of the direct operator control element (15) and a rotational axis (A) of the turn-and-push controller (13) are oriented in the same direction, wherein there is preferably provision that the rotational axis (A) of the direct operator control element (A) is arranged, when viewed in the radial direction, within a, in particular circular, radial outer contour (16) of the turn-and-push controller (13), and/or **in that** the rotational axis (A) of the direct operator control element (15) and the rotational axis (A) of the turn-and-push controller (13) are arranged congruently with respect to one another.

6. Operator control system according to one of the preceding claims, **characterized in that** an outer wall (18) of the direct operator control element (15) has an anti-slip structure which, when the direct operator control element (15) is activated, prevents and/or impedes slipping off from the direct operator control element (15), and/or **in that** the outer wall (18) has a structure by means of which the gripping of the direct operator control element (15) with the fingers is ergonomically assisted.

7. Operator control system according to one of the preceding claims, **characterized in that** at least one limiting element and/or stop element is provided, by means of which element rotation of the direct operator control element (15) in at least one rotational direction can be limited in such a way that the direct operator control element (15) can be rotated as far as a defined stop position, wherein there is preferably provision that the limiting element and/or stop element are/is embodied in such a way that the at least one stop position can be adjusted and/or set.

8. Operator control system according to one of the preceding claims, **characterized in that** a functional display device is provided, by means of which it can be displayed, in particular visually, to a user of the direct operator control element (15) and/or of the turn-and-push controller (13) whether the direct operator control element (15) and/or the turn-and-push controller (13) are/is functionally capable and/or can be used, in particular in the current menu item of the operator control menu.

9. Operator control system according to one of the preceding claims, **characterized in that** the assignment display device (19) has at least one display element (23) which is preferably arranged on the vehicle side, in particular a lighting element which is arranged on the vehicle side and by means of which the selected and/or pre-selected menu item can be displayed, and/or **in that** the assignment display device (19) is embodied in such a way that the displayed assignment of the main menu items to the defined rotational positions of the direct operator control element (15) can be set and/or adjusted.

10. Operator control system according to one of the preceding claims, **characterized in that** the assignment display device (19) is the operator control menu display device (3), in particular a screen, and/or is arranged underneath the operator control menu display device (3) when viewed in the direction of the vertical axis.

11. Operator control system according to one of the preceding claims, **characterized in that** the direct operator control element (15) and/or the turn-and-push controller (13) and/or the assignment display device (19) are/is arranged on a functional part of the vehicle and/or on a console (2), in particular on an instrument panel and/or on a centre console, of the vehicle.

12. Operator control system according to one of the preceding claims, **characterized in that** a feedback device (25) is provided, by means of which a visual and/or acoustic and/or haptic signal can be output as feedback to a user of the direct operator control element (15) when said user activates or has activated the direct operator control element (15).

13. Method for activating an operator control menu of a vehicle, in particular of a utility vehicle, having at least one display device (3), in particular a screen, which displays the operator control menu for controlling and/or activating vehicle functions, and having a rotatable and pressable turn-and-push controller (13), the rotational and pressure activation of which makes it possible to operate the operator control menu, wherein a rotatable direct operator control element (15) is assigned to the turn-and-push controller (13) and its rotational activation permits one of a plurality of different main menu items of the operator control menu to be selected and/or pre-selected directly, wherein the pre-selected main menu item and/or at least one sub-menu item in the selected main menu item are/is subsequently selected by means of the turn-and-push controller (13),
**characterized in that**
the operator control system is embodied in such a way that each of the directly selectable and/or pre-selectable main menu items is assigned in each case to a defined rotational position of the direct operator control element (15), wherein, by rotating the direct operator control element (15) into one of the defined rotational positions, the main menu item which is assigned to the rotational position is selected and/or pre-selected directly, and **in that** the operator control system is embodied in such a way that the assignment of the main menu items to the defined rotational positions is adjusted and/or set,
**in that** an assignment display device (19) is provided, by means of which the assignment of the main menu items to the defined rotational positions of the direct operator control element (15) is displayed to a user of the direct operator control element (15),
**in that** a sensor device and/or sensing device (27) is provided, by means of which a user's hand approaching the direct operator control element (15) is sensed and/or detected, and
**in that** the sensor device and/or sensing device (27) is connected in a signal-transmitting fashion to the assignment display device (19) in such a way that the assignment display of the main menu items is enlarged and/or highlighted and/or the assignment display is not displayed until the user's hand approaches the direct operator control element and/or is located in a close region which is specified in a defined fashion.

14. Vehicle, in particular utility vehicle, having an operator control system according to one of Claims 1 to 12.

## Revendications

1. Système de commande pour un véhicule, en particulier pour un véhicule utilitaire, comprenant au moins un dispositif d'affichage (3), en particulier un écran, affichant un menu de commande pour commander et/ou actionner des fonctions de véhicule et pourvu d'un bouton-poussoir rotatif (13) pouvant être tourné et pressé dont l'actionnement par rotation et par pression permet de commander le menu de commande, le bouton-poussoir rotatif (13) étant associé à un élément de commande directe (15) rotatif dont l'actionnement par rotation permet de sélectionner et/ou de présélectionner directement plusieurs éléments de menu principal différents du menu de commande, le bouton-poussoir rotatif (13) permettant de sélectionner l'élément de menu principal présélectionné et/ou au moins un élément de sous-menu dans l'élément de menu principal sélectionné,
**caractérisé en ce que**
le système de commande est réalisé de telle sorte que chacun des éléments de menu principal pouvant être sélectionnés et/ou présélectionnés directement est associé respectivement à une position de rotation définie de l'élément de commande directe (15), au moyen d'une rotation de l'élément de commande directe (15) dans l'une des positions de rotation définies l'élément de menu principal associé à la position de rotation pouvant être sélectionné et/ou présélectionné directement, et **en ce que** le système de commande est réalisé de telle sorte que l'association des éléments de menu principal aux positions de rotation définies peut être ajustée et/ou réglée,
**en ce qu'**un dispositif d'affichage d'association (19) est prévu qui permet d'afficher l'association des éléments de menu principal aux positions de rotation définies de l'élément de commande directe (15) pour un utilisateur de l'élément de commande directe (15),
**en ce qu'**un dispositif capteur et/ou de détection (27) est prévu qui permet de détecter et/ou de reconnaître qu'une main d'un utilisateur s'approche de l'élément de commande directe (15), et **en ce que** le dispositif capteur et/ou de détection (27) est relié au dispositif d'affichage d'association (19) pour la transmission de signaux.

2. Système de commande selon la revendication 1, **caractérisé en ce que** le bouton-poussoir rotatif (13) et l'élément de commande directe (15) sont associés l'un à l'autre de telle sorte que l'élément de commande directe (15) et le bouton-poussoir rotatif (13) peuvent être actionnés par une main d'un utilisateur du système de commande, en particulier d'un conducteur du véhicule, en particulier en même temps.

3. Système de commande selon la revendication 1 ou 2, **caractérisé en ce que** l'élément de commande directe (15) est réalisé en forme d'anneau, en particulier en forme d'anneau de cercle, d'anneau de réglage, et/ou **en ce que** l'élément de commande directe (15) entoure le bouton-poussoir rotatif (13) au moins par endroits en épousant ses contours et/ou avec un espacement d'interstice défini, en particulier en forme d'anneau.

4. Système de commande selon l'une quelconque des revendications précédentes, **caractérisé en ce que** l'élément de commande directe (15) est réalisé de manière conique, ayant une section transversale s'amincissant vers le haut, vue dans la direction de l'axe vertical (z), et/ou **en ce que** le bouton-poussoir rotatif (13), réalisé de préférence à la manière d'un bouton rotatif de type champignon, dépasse l'élément de commande directe (15) dans la direction d'axe vertical (z), et/ou **en ce que** le bouton-poussoir rotatif (13) est réalisé à symétrie de révolution.

5. Système de commande selon l'une quelconque des revendications précédentes, **caractérisé en ce qu'**un axe de rotation (A) de l'élément de commande directe (15) et un axe de rotation (A) du bouton-poussoir rotatif (13) sont alignés dans le même sens, dans lequel il est prévu de préférence que l'axe de rotation (A) de l'élément de commande directe (A), vu dans la direction radiale, soit disposé à l'intérieur d'un contour extérieur radial (16), en particulier circulaire, du bouton-poussoir rotatif (13), et/ou que l'axe de rotation (A) de l'élément de commande directe (15) et l'axe de rotation (A) du bouton-poussoir rotatif (13) soient disposés de manière congruente l'un par rapport à l'autre.

6. Système de commande selon l'une quelconque des revendications précédentes, **caractérisé en ce qu'**une paroi extérieure (18) de l'élément de commande directe (15) présente une structure antiglisse qui permet d'empêcher et/ou de contrer tout glissement sur l'élément de commande directe (15) lors d'un actionnement de l'élément de commande directe (15), et/ou **en ce que** la paroi extérieure (18) présente une structure qui assiste de manière ergonomique la préhension de l'élément de commande directe (15) avec les doigts.

7. Système de commande selon l'une quelconque des revendications précédentes, **caractérisé en ce qu'**au moins un élément de limitation et/ou de butée est prévu qui permet de limiter une rotation de l'élément de commande directe (15) dans au moins une direction de rotation de telle sorte que l'élément de commande directe (15) peut être tourné jusqu'à une position de butée définie, dans lequel il est prévu de préférence que l'élément de limitation et/ou de butée soit réalisé de telle sorte que ladite au moins une position de butée soit ajustable et/ou réglable.

8. Système de commande selon l'une quelconque des revendications précédentes, **caractérisé en ce qu'**un dispositif d'affichage de fonction est prévu qui permet d'afficher, en particulier de manière visuelle, pour un utilisateur de l'élément de commande directe (15) et/ou du bouton-poussoir rotatif (13) si l'élément de commande directe (15) et/ou le bouton-poussoir rotatif (13) sont opérationnels et/ou utilisables, en particulier sous l'élément de menu actuel du menu de commande.

9. Système de commande selon l'une quelconque des revendications précédentes, **caractérisé en ce que** le dispositif d'affichage d'association (19) présente au moins un élément d'affichage (23), disposé de préférence côté véhicule, en particulier un élément lumineux disposé côté véhicule qui permet d'afficher l'élément de menu sélectionné et/ou présélectionné, et/ou **en ce que** le dispositif d'affichage d'association (19) est réalisé de telle sorte que l'association affichée des éléments de menu principal aux positions de rotation définies de l'élément de commande directe (15) est réglable et/ou ajustable.

10. Système de commande selon l'une quelconque des revendications précédentes, **caractérisé en ce que** le dispositif d'affichage d'association (19) est le dispositif d'affichage de menu de commande (3), en particulier un écran, et/ou est disposé au-dessous du dispositif d'affichage de menu de commande (3), vu dans la direction d'axe vertical.

11. Système de commande selon l'une quelconque des revendications précédentes, **caractérisé en ce que** l'élément de commande directe (15) et/ou le bouton-poussoir rotatif (13) et/ou le dispositif d'affichage d'association (19) sont disposés sur une partie fonctionnelle du véhicule et/ou sur une console (2), en particulier sur un tableau de bord et/ou sur une console centrale, du véhicule.

12. Système de commande selon l'une quelconque des revendications précédentes, **caractérisé en ce qu'**un dispositif de réaction (25) est prévu qui permet de sortir comme réaction un signal optique et/ou acoustique et/ou haptique pour un utilisateur de l'élément de commande directe (15) si celui-ci actionne ou a actionné l'élément de commande directe (15).

13. Procédé permettant d'actionner un menu de commande d'un véhicule, en particulier d'un véhicule utilitaire, comprenant au moins un dispositif d'affichage (3), en particulier un écran, affichant le menu de commande pour commander et/ou actionner des fonctions de véhicule, et pourvu d'un bouton-poussoir rotatif (13) pouvant être tourné et pressé dont l'actionnement par rotation et par pression permet de commander le menu de commande, le bouton-poussoir rotatif (13) étant associé à un élément de commande directe (15) rotatif dont l'actionnement par rotation permet de sélectionner et/ou de présélectionner directement plusieurs éléments de menu principal différents du menu de commande, le bouton-poussoir rotatif (13) permettant ensuite de sélectionner l'élément de menu principal présélectionné et/ou au moins un élément de sous-menu dans l'élément de menu principal sélectionné,
**caractérisé en ce que**
le système de commande est réalisé de telle sorte que chacun des éléments de menu principal pouvant être sélectionnés et/ou présélectionnés directement est associé respectivement à une position de rotation définie de l'élément de commande directe (15), une rotation de l'élément de commande directe (15) dans l'une des positions de rotation définies sélectionnant et/ou présélectionnant directement l'élément de menu principal associé à la position de rotation, et **en ce que** le système de commande est réalisé de telle sorte que l'association des éléments de menu principal aux positions de rotation définies peut être ajustée et/ou réglée,
**en ce qu'**un dispositif d'affichage d'association (19) est prévu qui permet d'afficher l'association des éléments de menu principal aux positions de rotation définies de l'élément de commande directe (15) pour un utilisateur de l'élément de commande directe (15),
**en ce qu'**un dispositif capteur et/ou de détection (27) est prévu qui permet de détecter et/ou de reconnaître qu'une main d'un utilisateur s'approche de l'élément de commande directe (15), et
**en ce que** le dispositif capteur et/ou de détection (27) est relié au dispositif d'affichage d'association (19) pour la transmission de signaux de telle sorte que l'affichage d'association des éléments de menu principal est agrandi et/ou mis en évidence et/ou l'affichage d'association n'est affichage que si la main de l'utilisateur s'approche de l'élément de commande directe et/ou se trouve dans une zone de proximité spécifiée de manière définie.

14. Véhicule, en particulier véhicule utilitaire, comprenant un système de commande selon l'une quelconque des revendications 1 à 12.
